# EUROPÄISCHE PATENTSCHRIFT

(11) **EP 1 546 217 B1**
(45) Veröffentlichungstag und Bekanntmachung des Hinweises auf die Patenterteilung: **07.11.2007**
(21) Anmeldenummer: 03753288.4
(22) Anmeldetag: 09.09.2003
(51) Int. Cl.: C08F 8/02, H01L 51/30

(54) **PENTAARYLCYCLOPENTADIENYLEINHEITEN ALS AKTIVE EINHEITEN IN RESISTIVEN SPEICHERELEMENTEN**
PENTAARYLCYCLOPENTADIENYL UNITS AS ACTIVE UNITS IN RESISTIVE MEMORY ELEMENTS
UNITES PENTA-ARYLCYCLOPENTADIENYLE UTILISEES COMME UNITES ACTIVES DANS DES ELEMENTS DE MEMOIRE RESISTIFS

(30) Priorität: 30.09.2002 DE 10245539
(43) Veröffentlichungstag der Anmeldung: 29.06.2005
(73) Patentinhaber: Qimonda AG, 81739 München (DE)
(72) Erfinder: SCHMID, Günter, 91334 Hemhofen (DE); KLAUK, Hagen, 70195 Stuttgart (DE); HALIK, Marcus, 91058 Erlangen (DE); ENGL, Reimund, 90408 Nürnberg (DE); WALTER, Andreas, 91349 Egloffstein (DE)
(74) Vertreter: Kottmann, Heinz Dieter
(86) Internationale Anmeldenummer: PCT/DE2003/002994
(87) Internationale Veröffentlichungsnummer: WO 2004/031247

(56) Entgegenhaltungen:
- WO-A-98/28767
- DE-A- 19 632 949
- GB-A- 1 009 361
- DATABASE WPI Section EI, Week 199113 Derwent Publications Ltd., London, GB; Class U14, AN 1991-091907 XP002270985 & JP 03 037991 A (SEIKO EPSON CORP.), 19. Februar 1991 (1991-02-19)

## Beschreibung

Die Erfindung betrifft ein Polymer mit Halbleitereigenschaften sowie eine resistive Speicherzelle.

Halbleiterchips haben eine breite Verwendung in vielfältigen technischen Anwendungen gefunden. Sie beruhen meist auf Silizium als Halbleitersubstrat, in welches in zahlreichen Arbeitsschritten Halbleiterbauelemente integriert werden. Die Herstellung von Halbleiterchips ist daher aufwändig und teuer. Durch die Entdeckung elektrisch leitfähiger organischer Verbindungen ist der Weg zu mikroelektronischen Bauelementen geöffnet worden, welche nicht mehr auf anorganischen Halbleitermaterialien basieren, sondern auf synthetisch zugänglichen organischen Polymeren. Diese Verbindungen ermöglichen durch die Variabilität ihrer Struktur die Entwicklung von Materialien, welche speziell auf eine bestimmte Anwendung hin optimiert sind. Es sind auch bereits eine Reihe von mikroelektronischen Bauelementen entwickelt worden, wie Leuchtdioden oder Transistoren, welche die Eignung dieser organischen Materialien für die Herstellung hochintegrierter Schaltkreise demonstrieren. Einige dieser Bauelemente, wie beispielsweise Leuchtdioden, haben bereits einen solch hohen Entwicklungsstand erreicht, dass eine industrielle Fertigung möglich erscheint. Die Materialentwicklung für flüchtige bzw. nichtflüchtige Speicher auf der Basis organischer Polymere und Moleküle befindet sich jedoch noch weitgehend im Stadium der Forschung. A. Bune et al., Appl. Phys. Lett. 67 (26) (1995) 3975; A. Bune et al., Nature 391 (1998) 874 konnten zeigen, dass Materialien auf der Basis von PVDF (Poly-vinylidendifluorid), insbesondere ein Copolymer mit Trifluorethylen (PVDF-PTrFE; 70:30) als Material für Speicheranwendungen mit mittlerer bis geringer Dichte geeignet sind. Für die Anwendung als Speichermedium wird die Ferroelektrizität dieser Materialien genutzt.

Um höhere Speicherdichten erreichen zu können, muss die Größe der einzelnen Speicherelemente entsprechend verringert werden. Bei einer Größe der Strukturelemente von weniger als 100 nm sind Speicher, welche auf einer Änderung des elektrischen Widerstandes beruhen, gegenüber Speichern auf der Basis von Ferroelektrizität bevorzugt, da sich diese leichter elektrotechnisch auswerten lässt. Gao, H. J. et al., Phys. Rev. Lett. 84 (2000) 1780-1783 beschreiben ein Speicherkonzept, welches aus einem Donator-Akzeptorkomplex aus 1,4-Phenylendiamin und 3-Nitrobenzalmalonsäuredinitril beruht. Für die Speicherung von Information wird der Unterschied der elektrischen Leitfähigkeit zwischen amorpher und kristalliner Phase genutzt. Krieger H. Ju. et al., Syn. Met. 122 (2001) 199-202 beschreiben ein Konzept zur Herstellung von Speichern auf der Basis organischer Materialien, bei welchen die Dotierung und Dedotierung eines organischen π-konjugierten Halbleiters durch Salzzusätze genutzt wird, um eine Änderung der Leitfähigkeit von Schichten zu bewirken. Ma D. et al., Adv. Mater. 12(14) (2000) 1063-1066 beschreiben ein resistives Speicherelement, welches als Speichermedium ein Polymethacrylatderivat umfasst, welches seitenständig Anthracengruppen trägt. Das Poly (methylmethacrylat-co-9-anthracenyl-methyl-methacrylat) zeigt einen resistiven Hystereseeffekt. Bei Anlegen einer Spannung zeigt das Bauelement oberhalb einer kritischen Spannung (Vₖᵣᵢₜ.) eine elektrische Leitfähigkeit. Wird die angelegte Spannung anschließend wieder erniedrigt, bleibt das Bauelement elektrisch leitfähig, bis eine Schwellenspannung V_{hold} unterschritten wird, unterhalb welcher das Bauelement wieder in seinen nicht leitfähigen Zustand zurückkehrt.

Gegenwärtig stehen noch keine Speicherelemente auf der Basis organische Materialien zur Verfügung, welche eine industrielle Herstellung aussichtsreich erscheinen lassen.

Aufgabe der Erfindung ist es daher, neue Polymere mit interessanten elektrischen Eigenschaften zur Verfügung zu stellen.

Die Aufgabe wird gelöst durch ein organisches Polymer mit Halbleitereigenschaften, welches ein Polymerrückgrat und seitenständig an das Polymerrückgrat angebundene Pentaarylcyclopenta-1,3-dienylreste umfasst.

Der Cyclopentadienylrest lässt sich sehr leicht oxidieren, wobei ein Radikalkation erzeugt wird, das sich durch Abspaltung eines Protons stabilisieren kann. Durch die an die zentrale Cyclopentadienylgruppe gebundenen Arylreste entsteht ein ausgedehntes delokalisiertes π-Elektronensystem, in welchem das einzelne Elektron delokalisiert werden kann, wodurch das Radikal eine hohe Stabilität erhält. Durch Aufnahme eines Elektrons kann der Cyclopentadienylrest nach Addition eines Protons reversibel wieder in den Ausgangszustand zurückgeführt werden. Das erfindungsgemäße Polymer kann daher Löcher aufnehmen (bzw. Elektronen abgeben) und die Löcher im Polymer stabilisieren.

Die Pentaarylcyclopentadienylreste sind seitenständig an das Rückgrat des Polymers gebunden. Als Polymerrückgrat wird die Hauptkette des Polymers bezeichnet. Dieses dient in erster Linie der mechanischen Stabilität des Polymers, durch welche die Pentaarylcyclopentadienylreste in einer bestimmten Ordnung zueinander angeordnet werden können. Das Polymerrückgrat kann daher eine sehr große strukturelle Vielfalt aufweisen. An sich sind alle bekannten Polymerklassen geeignet. Beispiele sind Polyvinyle, Polyester, Polycarbonate, Polyamide oder auch Polyurethane. An die Polymerhauptkette sind nun über geeignete Gruppen, im einfachsten Fall über eine Einfachbindung, die Pentaarylcyclopentadienylreste gebunden. Die Anbindung an das polymere Rückgrat erfolgt dabei über eine der Arylgruppen, die dazu eine geeignete Gruppe trägt. Die an der Arylgruppe vorgesehene Gruppe wird passend zu denjenigen Gruppen ausgewählt, welche am Polymerrückgrat vorhanden sind. Wird das Polymerrückgrat beispielsweise von einem Polyacrylat gebildet, kann die Arylgruppe beispielsweise eine Hydroxygruppe oder eine Aminogruppe aufweisen, so dass der Pentaarylcyclopentadienylrest über eine Esterbindung oder eine Amidbindung an das Polymerrückgrat gebunden wird. Durch Copolymerisation entsprechend funktionalisierter Pentaarylcyclopenta-1,3-diene, die dazu eine entsprechende polymerisiserbare Kohlenstoff-Kohlenstoff-Doppelbindung umfassen, kann der Pentaarylcyclopentadienylrest über eine Kohlenstoff-Kohlenstoffbindung, oder, wenn ein entsprechendes (Meth)acrylat verwendet wird, über eine Esterbindung an das Polymerrückgrat gebunden werden.

Die an den zentralen Cyclopenta-1,3-dienylrest gebundenen Arylreste werden so ausgewählt, dass ein möglichst großes delokalisiertes π-Elektronenystem erzeugt werden kann. Die Arylreste können gleich oder verschieden sein und jeweils ein oder mehrere aromatische Ringsysteme umfassen.

Bevorzugt ist der zentrale Cyclpenta-1,3-dienylrest durch Phenylgruppen substituiert, welche wiederum ein- oder mehrfach durch weitere Gruppen, insbesondere Alkylgruppen substituiert sein können. Bevorzugt weist der Pentaarylcyclopenta-1,3-dienylrest eine Struktur der Formel I 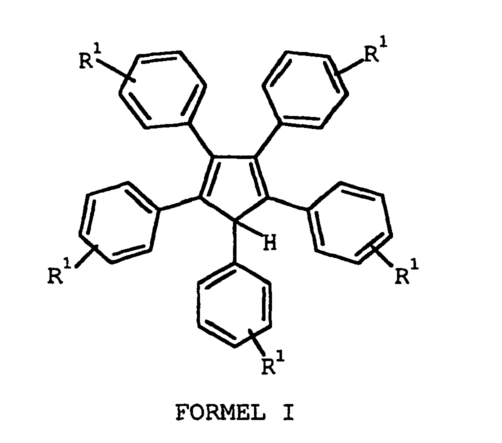 auf, wobei R¹ bevorzugt jeweils unabhängig für jede Position ein Wasserstoffatom, eine Alkylgruppe mit 1 bis 10 Kohlenstoffatomen oder eine Arylgruppe mit 5 bis 20 Kohlenstoffatomen bedeutet, wobei die Arylgruppe auch ein oder mehrfach substituiert sein kann, insbesondere mit einer Alkylgruppe mit 1 bis 10 Kohlenstoffatomen, einer Alkoxygruppe mit 1 bis 10 Kohlenstoffatomen oder Halogen. Weiter kann R¹ ein Halogenatom bedeuten, insbesondere Fluor, Chlor oder Brom, sowie eine Alkoxygruppe mit 1 bis 10 Kohlenstoffatomen, insbesondere eine Methoxy- oder eine Ethoxygruppe. R¹ kann in m- oder p-Stellung zur Bindung zum zentralen Cyclopentadienylrest angeordnet sein, wobei die p-Stellung bevorzugt ist. Einer der an den zentralen Cyclopentadienring gebundenen Phenylringe des Cyclopentadienylrests der Formel I trägt eine Gruppe, über welche der Pentaarylcyclopenta-1,3-dienylrest seitenständig an das Polymerrückgrat gebunden ist. Diese Gruppe ist im einfachsten Fall eine Einfachbindung. Die Gruppe für die Anknüpfung des Pentaphenylcyclopenta-1,3-dienylrests an das Polymerrückgrat kann innerhalb weiter Grenzen variiert werden und richtet sich, wie bereits oben beschrieben, nach den Gruppen, welche im Polymerrückgrat für eine Anknüpfung des Pentaarylcyclopentadienylrests zur Verfügung stehen. Beispielhafte Verbindungen, die eine Gruppe umfassen, mit welcher der Pentaarylcyclopentadienylrest an das Polymerrückgrat gebunden werden kann, sind im Folgenden dargestellt. In dem in Formel I dargestellten Grundkörper wird dazu entsprechend einer der Phenylgruppen mit einer entsprechenden reaktionsfähigen Gruppe substituiert. 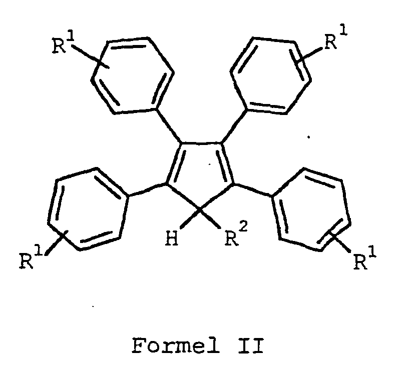 R²:

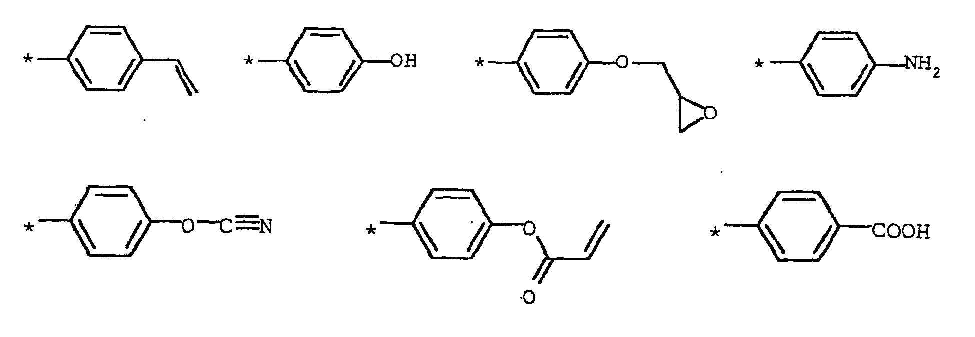

In Formel II ist die Gruppe, über welche eine Anbindung an das Polymerrückgrat erfolgt, am Phenylring in Position 5 der zentralen Cyclopentadienylgruppe vorgesehen. Die Gruppe, über welche die Anbindung an das Polymerrückgrat erfolgt, kann jedoch auch an jedem der anderen vier Phenylringe angeordnet sein. Entsprechend kann das am zentralen Cyclopentadienylrest angeordnete Wasserstoffatom an sich an einem beliebigen Kohlenstoffatom des zentralen Cyclopentadienylrests angeordnet sein. In den Gruppen R² sind die Gruppen, über welche eine Anbindung an das Polymerrückgrat erfolgt, jeweils in para-Stellung zur Bindung angeordnet, welche zum zentralen Cyclopentadienylrest führt. Die Gruppen können jedoch an sich auch an jedem anderen Kohlenstoffatom des Phenylrests angeordnet sein. Aus sterischen Gründen ist jedoch die p-Stellung bevorzugt.

Das Polymerrückgrat kann an sich beliebig gewählt werden, sofern es eine ausreichende mechanische Stabilität des Polymers gewährleistet. Bevorzugt ist das Polymerrückgrat aus Kohlenstoffatomen aufgebaut. Eine derartige Kohlenstoffkette lässt sich sehr einfach durch radikalische Polymerisation entsprechender ungesättigter Monomere erzeugen. Verfahren zur radikalischen Polymerisation sind dem Fachmann bekannt, so dass sich die Polymere sehr einfach erhalten lassen.

Neben einer rein mechanischen Funktion zur Stabilisierung des erfindungsgemäßen Polymers kann das Polymerrückgrat noch weitere Aufgaben übernehmen. Wie bereits oben erläutert, kann das Cyclopentadienylradikalkation durch Abspaltung eines Protons stabilisiert werden. Sind an das Polymerrückgrat protische Gruppen gebunden, können diese das freiwerdende Proton aufnehmen bzw. bei einer Reduktion des Radikals ein Proton abgeben, welches dann vom Cyclopentadienylrest aufgenommen wird.

Der räumliche Abstand der einzelnen Pentaarylcyclopentadienylgruppen an der Polymerkette kann eingestellt werden, indem zumindest ein zweites Comonomer vorgesehen wird, welches keinen Pentaarylcyclopentadienylrest trägt. Um ein Polymer mit einem Rückgrat aus einer Kohlenstoffkette zu erhalten, kann dann ein erstes Comonomer, welches eine polymerisierbare Kohlenstoff-Kohlenstoff-Doppelbindung und einen Pentaarylcyclopent-1,3-dienylrest aufweist mit zumindest einem zweiten Comonomer copolymerisiert werden, das eine polymerisierbare Kohlenstoff-Kohlenstoff-Doppelbindung aufweist. Das erste Comonomer wird dazu so ausgeführt, dass an einem der Phenylringe des Pentaphenylcyclopentylrests eine Gruppe mit einer polymerisierbaren Kohlenstoff-Kohlenstoff-Doppelbindung vorgesehen ist. Dies kann beispielsweise eine Vinylgruppe sein oder eine (Meth)acryloxygruppe. Das zweite Comonomer kann so ausgestaltet sein, dass neben der polymerisierbaren Kohlenstoff-Kohlenstoff-Doppelbindung keine weitere funktionelle Gruppe vorgesehen ist. Ein Beispiel für ein derartiges zweites Comonomer ist Styrol.

Das zweite Comonomer kann jedoch auch eine weitere funktionelle Gruppe tragen. Bevorzugt sind zweite Comonomere, welche eine protische Gruppe aufweisen. Unter einer protischen Gruppe wird eine Gruppe verstanden, welche ein Proton aufnehmen oder abgeben kann.

Bevorzugte Beispiele für zweite Comonomere, welche eine protische Gruppe aufweisen, sind p-Styrolsulphonsäure (Meth)acrylsäure, Vinylpyridin und Vinylpyrrolidinon.

Das Polymer kann aus nur zwei Comonomeren aufgebaut sein. Es ist aber auch möglich, noch weitere Comonomere vorzusehen. Beispielsweise kann neben den ersten Comonomeren, das den Pentaarylcyclopenta-1,3-dienylrest trägt, ein zweites Comonomer vorgesehen werden, das eine protische Gruppe trägt, sowie ein drittes Comonomer, das keine weitere funktionelle Gruppe trägt. Es ist auch möglich, Mischungen von Comonomeren zu verwenden, welche unterschiedliche protische Gruppen tragen. Ebenso können mehrere unterschiedliche Comonomere verwendet werden, die keine weitere funktionelle Gruppe aufweisen.

Die Halbleitereigenschaften des Polymers können durch die Anzahl der Pentaarylcyclopentadienylgruppen beeinflusst werden, die im Polymer enthalten sind. Die Anzahl dieser Gruppen kann durch das molare Verhältnis der Comonomeren eingestellt werden, aus welchen das erfindungsgemäße Polymer erhalten wird. Vorzugsweise sind erstes und zweites Comonomer bzw. erste und weitere Comonomere in einem molaren Verhältnis von 1:1 bis 100:1 im Polymer enthalten.

Das oben beschriebene Polymer zeigt einen resistiven Hystereseeffekt. Dieser Hystereseeffekt kann für die Herstellung von Speicherelementen genutzt werden. Gegenstand der Erfindung ist daher auch ein resistives Speicherelement mit einer Speicherzelle, welche zumindest einen ansteuerbaren ersten Kontakt, einen zweiten Kontakt und ein zwischen erstem und zweitem Kontakt angeordnetes Speichermedium umfasst, wobei das Speichermedium aus dem oben beschriebenen Polymer gebildet ist.

Wird an die Speicherzelle des resistiven Speicherelements eine Spannung angelegt, und diese langsam gesteigert, wirken die im erfindungsgemäßen Polymer enthaltenen Pentaarylcyclopentadienylreste als Fallen ("traps") für die Ladungsträger. Bei einer niedrigen Spannung fließt daher kein Strom durch die Speicherzelle. Wird die Spannung weiter gesteigert, wird schließlich eine kritische Spannung Vₖᵣᵢₜ. erreicht, bei welcher ein sprunghafter Anstieg der Stromstärke beobachtet wird. Die Speicherzelle geht also in einen leitenden Zustand über. In einer Modellvorstellung sind bei der kritischen Spannung Vₖᵢₜ. alle Ladungsträgerfallen im Speichermedium gefüllt. Es kann nun ein Transport der Ladungsträger durch das Speichermedium erfolgen. Wird nun die Spannung wieder verringert, verbleibt die Speicherzelle im leitenden Zustand, bis eine Spannung V_{hold} erreicht wird, bei welcher das Speichermedium wieder in einen nicht leitenden Zustand übergeht. Bei einer Spannung Vₛ, welche zwischen V_{hold} und Vₖᵣᵢₜ. liegt, können also zwei verschiedene Stromstärken gemessen werden, je nachdem, ob sich die Speicherzelle im leitfähigen oder im nicht leitfähigen Zustand befindet. Diesen beiden Zuständen können daher die Werte 1 und 0 zugeordnet werden. Soll das Speicherelement zwischen den Zuständen 0 und 1 geschaltet werden, muss entsprechend die an der Speicherzelle anliegende Spannung höher gewählt werden als Vₖᵣᵢₜ. oder geringer als V_{hold}.

Die Kontakte, durch welche die Ladungsträger dem Speichermedium zugeführt bzw. aus diesem abgeführt werden, bestehen aus einem Material, das eine möglichst hohe elektrische Leitfähigkeit aufweist. Geeignet sind zum Beispiel elektrisch leitfähige organische Polymere, wie Polyanilin oder Polythiophen, welche durch eine Dotierung eine hohe elektrische Leitfähigkeit erhalten.

Bevorzugt werden jedoch erster und zweiter Kontakt aus einem Metall hergestellt. Metalle zeigen eine sehr hohe elektrische Leitfähigkeit und lassen sich meist problemlos verarbeiten. Beispiele für geeignete Metalle sind Gold oder Aluminium.

Erster und zweiter Kontakt können aus dem gleichen Material aufgebaut sein. Beispielsweise können erster und zweiter Kontakt als Goldelektroden ausgebildet sein. Es ist aber auch möglich, ersten und zweiten Kontakt aus unterschiedlichen Materialien aufzubauen. Dies kann zum einen durch die Prozessbedingungen gegeben sein, unter welchen die Kontakte hergestellt werden. Beispielsweise lässt sich Aluminium sehr leicht mit Hilfe einer Schattenmaske auf eine Schicht des Speichermediums aufbringen. Werden für ersten und zweiten Kontakt unterschiedliche Materialien verwendet, besitzen diese unterschiedliche Austrittsarbeiten für die Ladungsträger. Auf diese Weise kann die Speicherzelle auch eine Diodencharakteristik annehmen, so dass bei einer Anordnung der Speicherzellen in Form einer Matrix parasitäre Ströme weitgehend unterdrückt werden können.

Bei Überschreiten der kritischen Spannung Vₖᵣᵢₜ. steigt die Stärke des durch die Speicherzelle fließenden Stroms sprungartig an. Um den Zustand der Speicherzelle bestimmen zu können, wird daher vorteilhaft ein konstanter Widerstand vorgesehen, welcher in Serie zur Speicherzelle geschaltet ist. Durch Messung des Spannungsabfalls über den konstanten Widerstand kann daher der Leitungszustand der Speicherzelle vereinfacht bestimmt werden.

Die Speicherzelle des erfindungsgemäßen resistiven Speicherelements lässt sich in sehr geringen Dimensionen ausführen und kann auch Abmessungen im Bereich von weniger als 100 mm annehmen. Auf einer gegebenen Fläche können daher eine große Anzahl von Speicherzellen angeordnet werden, beispielsweise in Form einer Matrix. Gegenstand der Erfindung ist daher auch ein Speicherfeld, welches zumindest zwei zwischen zwei Informationszuständen schaltbare Speicherelemente umfasst, wobei eine Steuereinrichtung vorgesehen ist, mit welcher der Informationszustand jedes Speicherelements gesteuert werden kann.

Die Ausgestaltung des Speicherfelds kann dabei in üblicher Weise erfolgen. Beispielsweise können unterhalb und oberhalb einer Schicht aus dem oben beschriebenen Polymer Wort- und Bitlinien angeordnet sein, an deren Kreuzungspunkten jeweils eine Speicherzelle ausgebildet wird. Durch Anlegen einer Spannung zwischen einer bestimmten Wort- und einer bestimmten Bitleitung kann dann der Informationsgehalt einer bestimmten Speicherzelle geändert oder ausgelesen werden. Es ist aber auch möglich, jeder einzelnen Speicherzelle einen Transistor zuzuordnen, mit welchem der Informationszustand dieser Zelle gesteuert wird.

Die Erfindung wird anhand von Beispielen sowie unter Bezugnahme auf die beigefügten Figuren näher erläutert. Dabei zeigt:
- Fig. 1: ein Elektronspinresonanzspektrum des Pentaphenylcyclopentadienylradikals;
- Fig. 2: eine Strom-Spannungskurve, wie sie mit dem erfindungsgemäßen Speicherelement erhalten wird;
- Fig. 3: eine schematische Darstellung eines Schaltkreises, wie er zum Beschreiben und Auslesen der Speicherzelle verwendet wird;
- Fig. 4: eine Kurve, in welcher ein Schaltvorgang der Speicherzelle zwischen den Zuständen 1 und 0 dargestellt ist;
- Fig. 5: ein Speicherfeld, welches als passive Matrix ausgestaltet ist;
- Fig. 6: ein IR-Spektrum von 2,3,4,5-Tetraphenylcyclopent-2-enon;
- Fig. 7: ein IR-Spektrum von 1,3-bis-(p-Tolyl)-2-propanon;
- Fig. 8: ein IR-Spektrum von 4,4'-Dimethylbenzoin;
- Fig. 9: ein IR-Spektrum von 4,4'-Dimethylbenzil;
- Fig. 10: ein IR-Spektrum von 1,2,3,4-Tetra(p-tolyl)-cyclopenta-1,3-dien-5-on.

Die im erfindungsgemäßen Polymer enthaltenen Pentaarylcyclopentadienyleinheiten können den Zustand gefüllter Traps in einer Speicherzelle stabilisieren und ermöglichen dadurch die Entstehung von Strompfaden. Pentaarylcyclopentadienylradikale sind äußerst stabil und senken damit die Empfindlichkeit des Systems gegenüber äußeren Einflüssen. Wird durch Oxidation ein Loch in die polymergebundene Cyclopentadienyleinheit injiziert, bildet sich ein Radikalkation. Das an der Cyclopentadienylgruppe gebundene Proton kann abgespalten werden und zum Beispiel vom Polymerrückgrat aufgenommen werden. Bei der Rückführung in den Grundzustand durch Reduktion des Cyclopentadienylradikals wird das Proton wieder aufgenommen. Das System kann reversibel in die beiden Zustände überführt werden. Der Mechanismus einer Lochinjektion in das Speichermedium ist im Folgenden schematisch dargestellt:

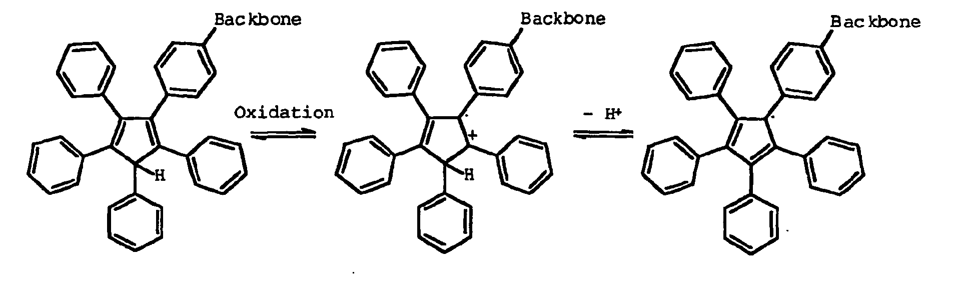

Das Polymerrückgrat sowie die Gruppe, mit welcher der Pentaphenylcyclopentadienylrest an diesem angebunden ist, ist als "Backbone" bezeichnet.

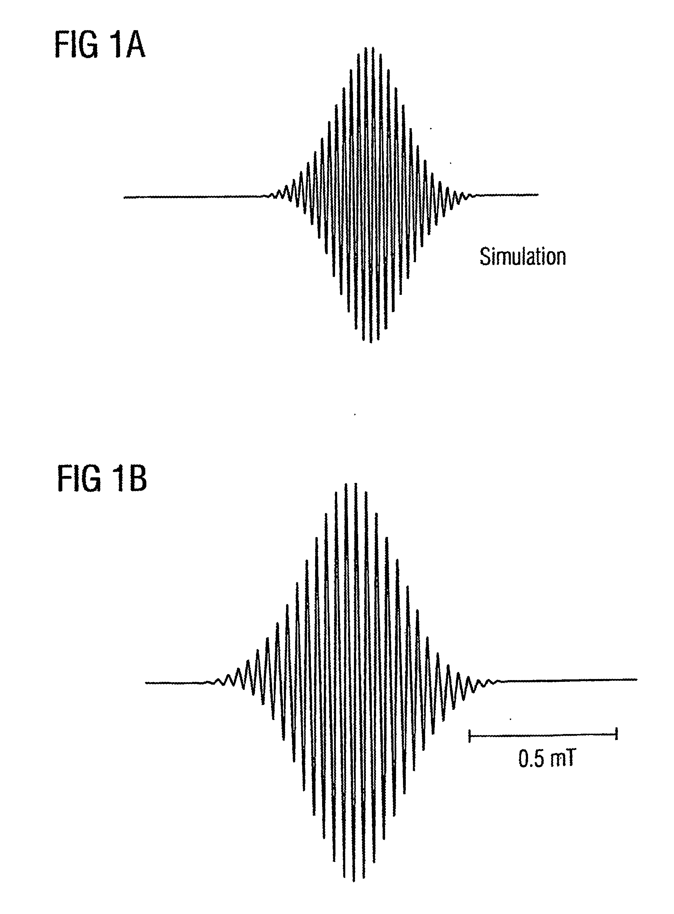

Das radikalische Elektron ist über alle Kohlenstoffatome des Pentaphenylcyclopentadienylsystems delokalisiert. Dies zeigt das in Fig. 1 dargestellte Elektronenspinresonanzspektrum. Fig. 1a zeigt das simulierte ESR-Spektrum von C₅Ph₅^{•}. Es wurde davon ausgegangen, dass das ungepaarte Elektron mit den 15 ortho- und para-ständigen H-Atomen mit der Kopplungskonstante 2a koppelt. Jede dieser 16 Linien wird durch Kopplung mit den 10 metaständigen H-Atomen in 11 Linien aufgespalten (Kopplungskonstante a). Das Spektrum enthält damit 41 Linien. In Fig. 1b ist das gemessene ESR-Spektrum des Pentaphenylcyclopentadienylradikals dargestellt (g = 2,00308, Kopplungskonstante a = 0,20 - 0,35 G, mindestens 31 Linien sichtbar).

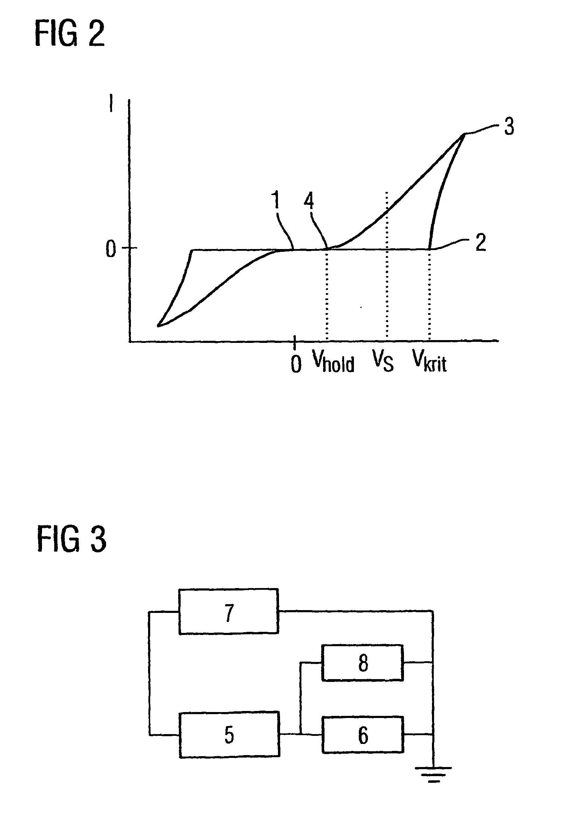

Fig. 2 zeigt eine Strom-Spannungskurve, die erhalten wird, wenn eine erfindungsgemäße Speicherzelle mit einem konstanten Widerstand in Serie geschaltet wird und der Spannungsabfall über den Widerstand gemessen wird. Geht man vom spannungslosen Zustand 1 aus und erhöht die Spannung kontinuierlich, fließt kein Strom, bis schließlich bei einer kritischen Spannung V_{krit.}, 2, die Speicherzelle in den leitenden Zustand übergeht. Die Stärke des Stroms steigt sprunghaft an, wobei bei einer weiteren Steigerung der Spannung der Strom im Wesentlichen vom konstanten Widerstand bestimmt wird. Wird die Spannung, nachdem die Speicherzelle in den leitfähigen Zustand geschaltet wurde (3) wieder verringert, so verbleibt die Speicherzelle im leitfähigen Zustand, so dass die Steigung der Strom-Spannungskurve im Wesentlichen vom konstanten Widerstand bestimmt wird. Bei einer bestimmten Spannung (V_{hold}, 4) geht die Speicherzelle wieder in den elektrisch nicht leitfähigen Zustand über, so dass kein Strom mehr durch den konstanten Widerstand fließt. Für eine Spannung Vₛ, welche zwischen V_{hold} und Vₖᵣᵢₜ. liegt, bedeutet dies, dass zwei verschiedene Stromstärken gemessen werden, je nachdem, ob sich die Speicherzelle im elektrisch leitenden oder im elektrisch nicht leitenden Zustand befindet.

Fig. 3 zeigt schematisch eine Anordnung, mit welcher eine erfindungsgemäße Speicherzelle 5 beschrieben bzw. ausgelesen wird. In Serie zur Speicherzelle 5 ist ein konstanter Widerstand 6 geschaltet. Um die Speicherzelle 5 zu beschreiben, ist ein Schreibkreis 7 vorgesehen, mit welchem eine Spannung an die Speicherzelle 5 angelegt werden kann, welche größer ist als Vₖᵣᵢₜ. um die Speicherzelle 5 in den leitfähigen Zustand zu schalten bzw. niedriger ist als V_{hold}, um die Speicherzelle 5 in den nicht leitfähigen Zustand zu schalten. Um die in der Speicherzelle 5 gespeicherte Information wieder auslesen zu können, das heißt, um feststellen zu können, ob sich die Speicherzelle im leitfähigen oder nicht leitfähigen Zustand befindet, wird an die Speicherzelle 5 eine konstante Spannung Vₛ angelegt, welche zwischen der Spannung V_{hold} und der Spannung Vₖᵣᵢₜ. liegt. Mit dem Lesekreis 8 kann dann der Spannungsabfall über den konstanten Widerstand 6 gemessen werden, welcher dann den beiden Zuständen 1 und 0 der Speicherzelle 5 zugeordnet wird.

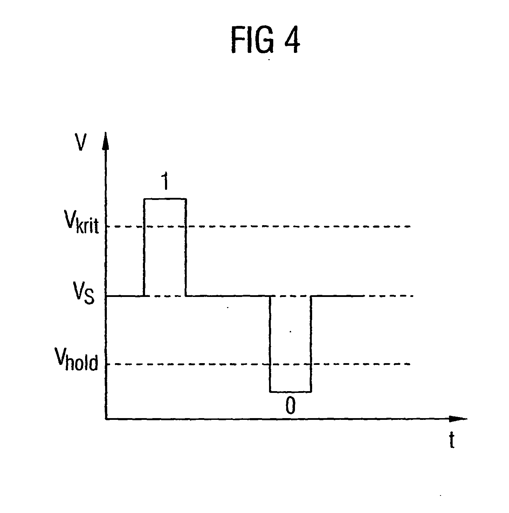

Fig. 4 zeigt schematisch den Verlauf der an die Speicherzelle 5 angelegten Spannung während des Schreibvorgangs. Um die in der Speicherzelle 5 gespeicherte Information zu erhalten, wird die Speicherzelle 5 bei einer Spannung Vₛ gehalten, welche größer ist als V_{hold} und geringer ist als Vₖᵣᵢₜ.- Um die Speicherzelle 5 in den leitfähigen Zustand zu schalten, wird eine Spannung angelegt, die größer ist als V_{krit.} . Die Speicherzelle 5 befindet sich nun im leitfähigen Zustand, welchem beispielsweise der Zustand 1 zugeordnet ist. Dieser Zustand bleibt erhalten, solange die Spannung Vₛ an der Speicherzelle 5 anlegt. Um die Speicherzelle 5 aus dem leitfähigen Zustand in den nicht leitfähigen Zustand zu schalten, wird die an der Speicherzelle 5 angelegte Spannung auf einen Wert abgesenkt, der niedriger ist als V_{hold}. Dem nicht leitfähigen Zustand ist in Fig. 3 der Wert 0 zugeordnet. Wird die Spannung anschließend wieder bis auf Vₛ erhöht, verbleibt die Speicherzelle 5 im nicht leitfähigen Zustand, das heißt im Informationszustand 0. Beim Auslesen der Speicherzelle 5 wird entsprechend über den Widerstand 6 ein Spannungsabfall von 0 gemessen.

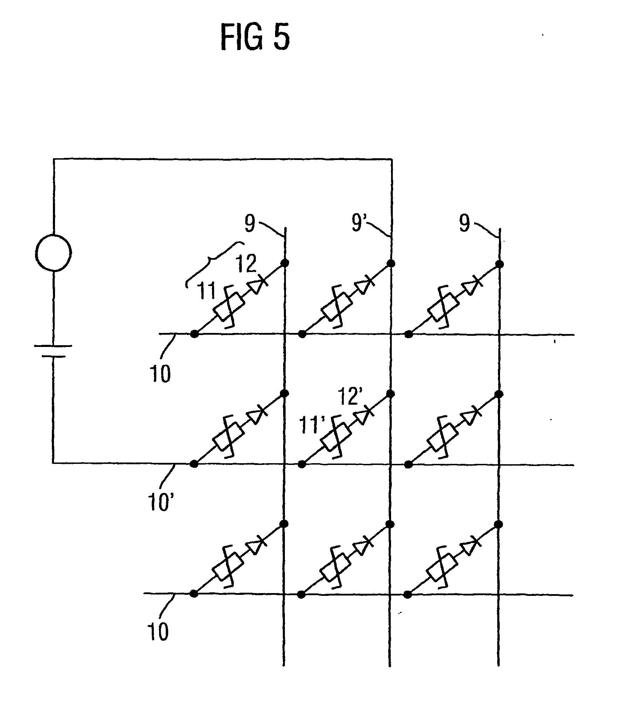

In Fig. 5 ist schematisch eine Matrixanordnung gezeigt, in welcher die erfindungsgemäßen resistiven Speicherelemente durch Dioden entkoppelt sind. Die Matrix wird von Spaltenleitungen 9 und Zeilenleitungen 10 gebildet. Jedes aus einer Speicherzelle 11 und einer Diode 12 gebildete Bauelement ist jeweils mit einer Spaltenleitung 9 und einer Zeilenleitung 10 verbunden. Soll beispielsweise die Speicherzelle 11' vom Zustand 0 in den Zustand 1 geschaltet werden, wird dazu an die Spaltenleitung 9' und die Zeilenleitung 10' eine Spannung angelegt, welche größer ist als V_{krit.}. Dabei ist selektiv nur die Diode 12' in Durchlassrichtung geschaltet, während alle anderen möglichen Strompfade immer mindestens eine Diode 12 in Sperrrichtung enthalten. Damit kann selektiv die elektrische Leitfähigkeit bzw. der Informationsgehalt der Speicherzelle 11' geschaltet werden. Fig. 4 zeigt nur eine Möglichkeit zur Entkopplung der Speicherzellen 11 in einem Speicherfeld. Es ist aber ebenso möglich, Zeilen- und Spaltenleitungen beispielsweise durch Transistoren zu entkoppeln. Zum Beschreiben der Speicherzelle wird dann jeweils nur der zugeordnete Transistor in den leitfähigen Zustand geschaltet. Neben der gezeigten Matrixanordnung sind auch Speicherfelder möglich, in welches jedes resistive Speicherelement selektiv durch einen Transistor beschrieben bzw. ausgelesen werden kann.

Die für die Herstellung des Polymers erforderlichen Pentaarylcyclopentadiene können auf unterschiedlichen Wegen dargestellt werden. Ein erster Syntheseweg ist im Folgenden schematisch dargestellt. Der Einfachheit halber sind Substituenten an den Arylringen nicht wiedergegeben. Einer der Phenylringe trägt eine Gruppe (nicht dargestellt), die eine Anbindung an das Polymerrückgrat ermöglicht.

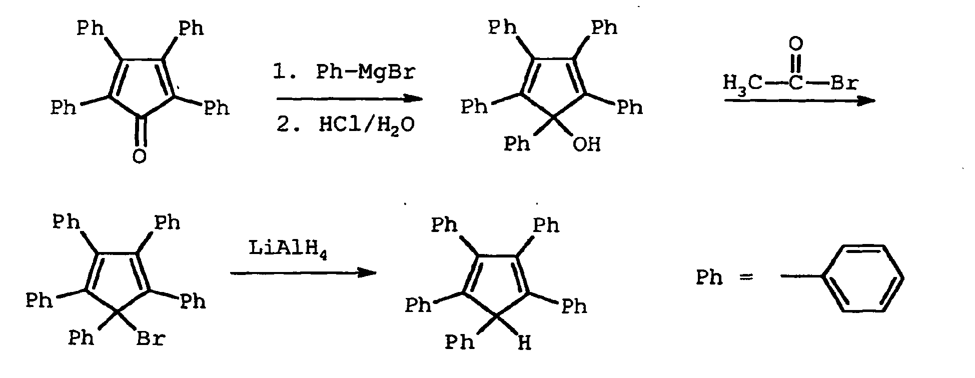

Der dargestellte Syntheseweg beruht auf Arbeiten von Ziegler und Schnell (K. Ziegler, B. Schnell, Liebigs Ann. Chem. 445 (1925), 266). Ausgehend vom Tetraarylcyclopentadienon wird zunächst mit einem Grignard-Reagenz eine fünfte Phenylgruppe in das Molekül eingeführt. Durch wässrige saure Aufarbeitung gelangt man zum 1,2,3,4,5-Pentaarylcyclopenta-1,3-dien-5-ol. Das Arylmagnesiumbromid wird dabei im Überschuss eingesetzt. Anschließend wird die Hydroxygruppe mit Acetylbromid ins Bromid überführt. Durch Reduktion mit einem geeigneten Reduktionsmittel, zum Beispiel LiAlH₄, wird schließlich das gewünschte Pentaarylcyclopenta-1,3-dien erhalten.

Eine weitere Syntheseroute ist im Folgenden gezeigt:

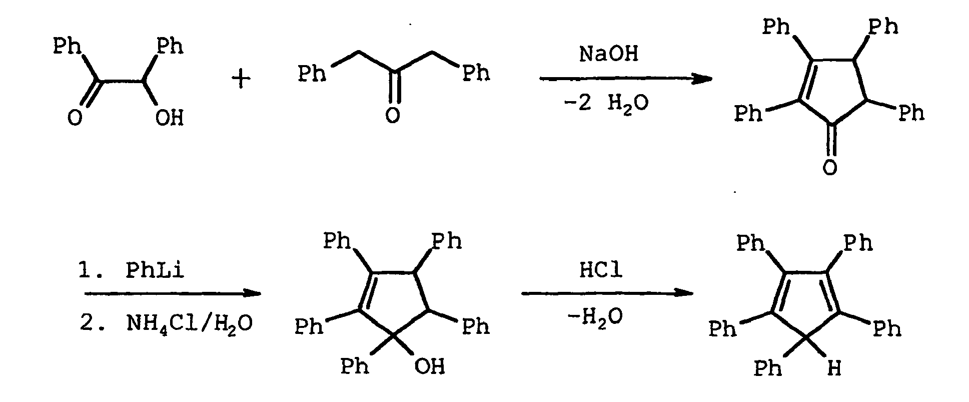

Der Syntheseweg geht von 2,3,4,5-Tetraarylcyclopent-2-enon aus, dem Kondensationsprodukt aus Benzoin und 1,3-Diphenylaceton. Das 2,3,4,5-Tetraphenylcyclopenten-2-on reagiert mit einem Überschuss Aryllithium zu 1,2,3,4,5-Pentaarylcyclopenta-2,4-dien-1-ol. Durch anschließende Eliminierung von Wasser wird das gewünschte 1,2,3,4,5-Pentaarylcyclopenta-1,3-dien erhalten.

### Beispiel 1:

### 1,2,3,4-Tetraphenyl-5-p-vinylphenylcyclopenta-1,3-dien

### 1,2,3,4-Tetraphenyl-5-p-vinylphenylcyclopenta-1,3-dien-5-ol

46,2 g (0,12 mol) Tetraphenylcyclopentadienon wurden mit 0,61 mol p-Vinylphenylmagnesiumbromid in 400 ml Ether und anschließender Hydrolyse zu 1,2,3,4-Tetraphenyl-5-p-vinylphenylcyclopenta-1,3-dien-5-ol umgesetzt. Elementaranalyse für C₃₇H₂₈O: gef.: C 90,91 %, H 5, 75 %, ber.: C 90,85 %, H 5,78 %)

### 5-Brom-1,2,3,4-Tetraphenyl-5-2-vinylphenylcyclopenta-1,3-dien

53,74 g (0,11 mol) 1,2,3,4-Tetraphenyl-5-p-vinylphenylcyclopenta-1,3-dien-5-ol wurden in 300 ml Toluol suspendiert. Innerhalb von 20 Minuten wurden bei Raumtemperatur 74 g (0,6 mol) Acetylbromid zugetropft und der Reaktionsansatz anschließend 2 Stunden unter Rückfluss gekocht. Gegen Ende der Reaktion wurden noch 2 ml Methanol tropfenweise zugegeben. Überschüssiges Acetylbromid und Toluol wurden im Vakuum abdestilliert. Das zurückbleibende Öl kristallisierte nach Zugabe von 100 ml Petrolether. Der orange Niederschlag wurde abgesaugt, mit Petrolether nachgewaschen und getrocknet. Das Produkt wurde für die weiteren Synthesen verwendet. Analysenreine orange Produkte wurden durch Rekristallisation aus Toluol erhalten. (Ausbeute: 55,15 g (91 %); Elementaranalyse für C₃₇H₂₇Br: gef.: C 80,62 %, H 4,89 %, ber.: C 80,58 %, H 4,93 %) .

### 1,2,3,4-Tetraphenyl-5-p-vinylphenylcyclopenta-1,3-dien

Zu einer Suspension von 11,5 g (0,3 mol) Li[AlH₄] in 150 ml Ether wurde portionsweise eine Suspension von 55,1 g (0,1 mol) 5-Brom-1,2,3,4-Tetraphenyl-5-p-vinylphenylcyclopenta-1,3-dien in 300 ml Ether unter Rühren zugegeben. Die entstandene leicht gelbgraue Suspension wurde zur Vervollständigung der Reduktion noch 2 Stunden unter Rückfluss gekocht. Nach dem Abkühlen auf Raumtemperatur wurde überschüssiges Li[AlH₄]zunächst mit Eiswasser (Vorsicht: stürmische H₂-Entwicklung) und dann mit verdünnter Salzsäure hydrolysiert. Mit dem Rotationsverdampfer wurden anschließend alle flüchtigen organischen Bestandteile aus dem Reaktionsgemisch abdestilliert. Das leicht gelbe Rohprodukt wurde abgesaugt und mehrere Male mit Wasser gewaschen. Zur weiteren Reinigung wurde es mit Toluol azeotrop getrocknet, filtriert und umkristallisiert (Ausbeute 39,65 g (84 %) ; gef.: C 99,09 %, H 5,81 %, ber.: C 94,03 %, H 5,97 %.

### Beispiel 2:

### 1,2,4,5-Tetraphenyl-3-p-vinylphenylcyclopenta-1,3-dien

### 2,3,4,5-Tetraphenylcyclopent-2-enon (M = 386,5 g/mol)

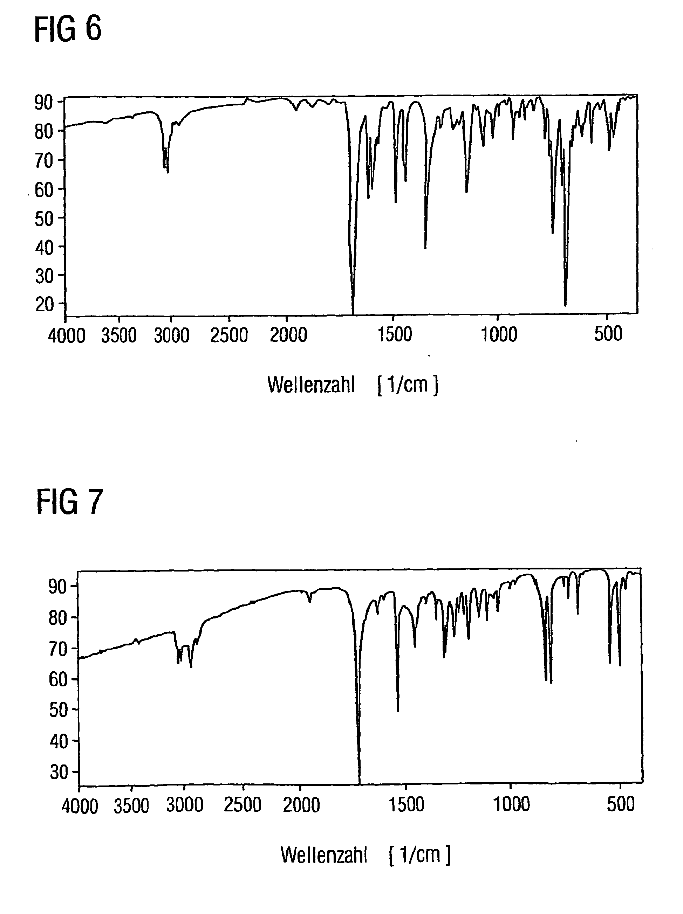

2,3,4,5-Tetraphenylcyclopent-2-enon wurde gemäß einer Vorschrift von Dithey und Quit aus Dibenzylketon und Benzoin dargestellt (Ausbeute 59 %; Fp.: 162 - 163°C, Lit.: 162 - 163°C, Elementaranalyse für C₂₉H₂₂O: gef.: C 89,4 %, H 6,0 %; ber.: C 90,12 %, H 5,7 %). Das IR-Spektrum von 2,3,4,5-Tetraphenylcyclopent-2-enon ist in Fig. 6 wiedergegeben.

W. Dilthey, O. Trösken, K. Plum, W. Schommer, J. prakt. Chem. 141 (1934) 331

### 1,2,4, 5-Tetraphenyl-3-p-vinylphenylcyclopenta-1,3-dien (472,63 g/mol)

1,2,9,5-Tetraphenyl-3-p-vinylphenylcyclopenta-1,3-dien wurde aus 37,8 g (0,098 mol) 2,3,4,5-Tetraphenylcyclopent-2-enon und 0,5 mol p-Vinylphenyllithium (aus 7 g (1 mol) Li und 91,52 g (0,5 mol Bromstyrol) in 300 ml Ether dargestellt und analog 1,2,3,4-Tetraphenyl-5-p-vinylphenylcyclopenta-1,3-dien gereinigt. (Ausbeute 37 g (80 %)

### Beispiel 3:

### 1,2,3,4-Tetra-p-toly-5-p-vinylphenylcyclopenta-1,3-dien

### 1,3-Bis(p-tolyl)-2-propanon (M = 210,28 g/mol)

Isopropylmagnesiumbromid wurde aus 24,3 g (1 mol) Mg und 123 g Isopropylbromid (1 mol) in 500 ml Ether dargestellt (Standardmethode zur Darstellung von Gridnardreagenzien). Zu dieser Lösung wurden bei 0°C langsam unter Rühren 100 g (0,56 mol) p-Tolylessigsäureethylester getropft, wobei Propanentwicklung einsetzte und ein grauer Niederschlag ausfiel. Das Reaktionsgemisch wurde über Nacht bei Raumtemperatur stehengelassen und zunächst mit 10 %-iger NH₄Cl-Lösung, dann mit verdünnter Salzsäure hydrolysiert. Die Etherphase wurde abgetrennt und die wässrige Phase mit Ether extrahiert. Die vereinigten organischen Phasen wurden mit verdünnter NaOH und Wasser gewaschen und über Na₂SO₄ getrocknet. Nach dem Abziehen des Lösungsmittels bliebt der β-Ketoester in Form eines fast farblosen Öls zurück. Er wurde in 1 1 Eisessig gelöst und mit 150 ml 18 %-iger HCl so lange unter Rückfluss erhitzte bis über einen Blasenzähler keine CO₂-Entwicklun mehr beobachtet werden konnte. Der Ansatz wurde bis auf 150 ml eingeengt, mit 10 %-iger Natronlauge neutralisiert und mehrmals mit Ether extrahiert. Die vereinigten Etherphasen wurden über Na₂SO₄ getrocknet. Nach Abziehen des Ethers blieb 1,3-Bis-(p-tolyl)propanon als helloranges Öl zurück. In 100 ml Pentan aufgenommen, kristallisierten über Nach über 1 cm große plattenförmige, weiche Kristalle aus (Ausbeute: 50,0 g (75 %); Fp.: 55 - 56°C, Lit.: 53,2 - 54,4°C [15], 30 - 32°C [16], Elementaranalyse: gef.: C 85,7 %, H 7,5 %, ber.: C 85,67 %, H 7,61 %). Das IR-Spektrum von 1,3-Bis(p-tolyl)-2-propanon ist in Fig. 7 dargestellt.

### Literatur:

S. B. Coan, D. E. Trucker, E. I. Becker, J. Amer. Chem. Soc. 77 (1955) 60;
L. D. Field, Inorg. Chem. 32 (1993) 211.

### Kristalldaten und Strukturbestimmung von 1,3-Bis(p-tolyl)-2-propanon

Die Röntgenmessungen erfolgten mit graphitmonochromatisierter MoK_{α}-Strahlung (λ = 0,71069_) an einem etwas zu großen Kristall (1,0 mm x 1,0 mm x 0,5 mm) bei Raumtemperatur auf dem Huberdiffraktometer. Der Kristall wurde mit Epoxidkleber auf einen Glasfaden aufgeklebt. Kristalldaten von 1,3-Bis(p-tolyl)-2-propanon (C₁₇H₁₈O, M = 283,3 g/mol): monoklin, Raumgruppe C2/c, Gitterkonstanten a 27,118 (18), b 6, 112 (4) , c 8,673(6) _, β 98,076(38)°, Z = 4, D_{ber} = 1, 112 g · cm⁻³, µ = 0,35 cm⁻¹. Die Intensitätsdaten wurden im θ/2θ-Betrieb gesammelt; 2θmax = 50°. Von den 1135 unabhängigen beobachteten Reflexen wurden 970 Reflexe mit Fₒ > 2σ(Fₒ) für die weiteren Rechnungen verwendet. Die Struktur wurde durch iterierte symbolische Addition vollständig gelöst. Alle Nicht-Wasserstoffatome wurden anisotrop verfeinert. Wasserstoffe wurden in berechneter Position, auf den jeweiligen Kohlenstoffatomen reitend, in die Verfeinerung einbezogen. Der abschließende R-Wert betrug 0,107. Die maximale Restelektronendichte lag bei 0,3 e/_³ (Atomparameter siehe Tabelle 1).

**Tabelle 1: Atomparameter von 1,3-Bis(p-tolyl)-2-propanon**

| Atom | X | Y | Z | U11 | U22 | U33 | U23 | U13 | U12 |
|---|---|---|---|---|---|---|---|---|---|
| C(1) | 0.5000 | 0.009(2) | 0.7500 | 0.046 | 0.083(7) | 0.046(5) | 0.000 | -0.021(4) | 0.000 |
| O(1) | 0.5000 | -0.186(1) | 0.7500 | 0.064(4) | 0.085(6) | 0.124(7) | 0.000 | -0.032(4) | 0.000 |
| C(20) | 0.4611(2) | 0.014(1) | 0.8239(6) | 0.054(3) | 0.118(7) | 0.034(3) | -0.004(4) | -0.006(3) | 0.001(4) |
| C(21) | 0.4180(2) | 0.203(1) | 0.6953(6) | 0.047(3) | 0.071(4) | 0.040(3) | -0.005(3) | 0.011(2) | 0.001(3) |
| C(22) | 0.4156(2) | 0.405(1) | 0.6268(7) | 0.057(4) | 0.068(5) | 0.063(4) | -0.004(4) | 0.009(3) | -0.009(3) |
| C(23) | 0.3764(2) | 0.459(1) | 0.5078(8) | 0.068(4) | 0.070(5) | 0.067(4) | 0.012(4) | 0.017(3) | 0.007(4) |
| C(24) | 0.3395(2) | 0.305(1) | 0.4621(7) | 0.047(3) | 0.083(5) | 0.052(4) | 0.001(4) | 0.009(3) | 0.013(4) |
| C(25) | 0.3422(2) | 0.102(1) | 0.5301(7) | 0.043(3) | 0.078(5) | 0.067(4) | -0.007(4) | 0.004(3) | -0.006(3) |
| C(26) | 0.3815(2) | 0.046(1) | 0.6484(7) | 0.050(3) | 0.066(4) | 0.060(4) | 0.006(3) | 0.014(3) | -0.001(3) |
| C(3) | 0.2972(2) | 0.366(2) | 0.3325(8) | 0.056(4) | 0.149(9) | 0.078(5) | 0.011(5) | -0.010(4) | 0.026(5) |

### 4.4'-Dimethylbenzoin (M = 240.3 g/mol)

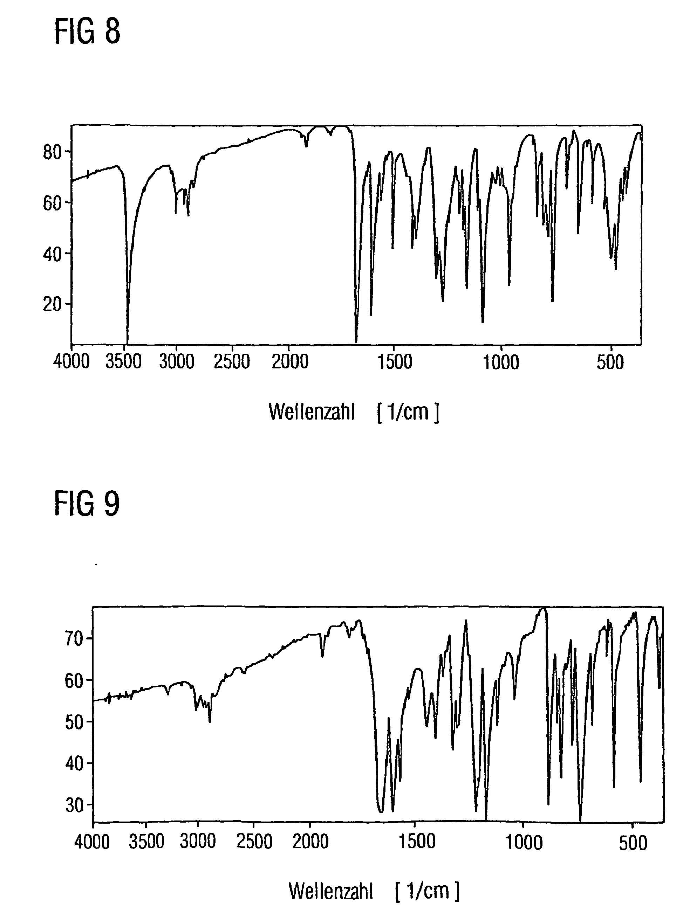

250 g (2,08 mol) p-Methyl-benzaldehyd wurden mit Hilfe von 30 g (0,46 mol) KCN zu 4,4'-Dimethylbenzoin gemäß einer Standardvorschrift [Lit.] kondensiert. Das Rohprodukt wurde ohne weitere Reinigung eingesetzt (Ausbeute roh: gef.: C 80,0 %, H 6,4 %, ber.: 79,97 %, H 6,71 %). Das IR-Spektrum von 4,4'-Dimethylbenzoin ist in Fig. 8 dargestellt.

### Literatur:

Organikum 18. Auflage (1990) 457 4-4'-Dimethylbenzil (M= 238,3 g/mol)

4,4'-Dimethylbenzil wurde in Anlehnung an eine Vorschrift für Benzil dargestellt [Lit.]. 420 g CUSO₄. 5 H₂O (1,68 mol) wurden unter Erwärmen in einem Gemisch aus 350 ml Wasser und 400 ml Pyridinbasen gelöst. Zu der noch warmen Lösung wurden 190 g (0,79 mol) rohes 4,4'-Dimethylbenzoin gegeben und 4 Stunden unter Rückfluss erhitzt. Nach dem Abkühlen auf Raumtemperatur wurde das Rohprodukt abfiltriert und mit Wasser gewaschen. Der Filterrückstand wurde in Ether aufgenommen, filtriert und mit Na₂SO₄ getrocknet. Nach dem Einengen der Lösung auf ca.500 ml kristallisiert 4,4'Dimethylbenzil in Form fahlgelber Kristalle aus. Je nach Einsatz wurden sie nochmals aus Ethanol umkristallisiert (Ausbeute 119,9 g (64 % bezogen auf eingesetztes rohes 4,4'-Dimethylbenzoin); Fp.: 104°C, Lit.: 104-105°C. Das IR-Spektrum von 4-4'-Dimethylbenzil ist in Fig. 9 dargestellt.

### Literatur:

L. F. Tietze, Th. Eicher, Reaktionen und Synthesen R. Stierlein, Chem. Ber. 22/1 (1889) 37

### 1,2,3,4-Tetra(p-tolyl)cyclonenta-1,3-dien-5-on (M = 440,58 g/mol)

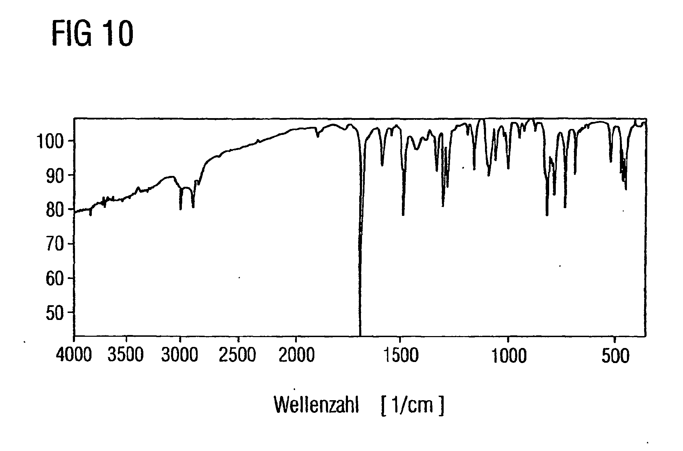

23,13 g (0,11 mol) 1,3-Bis(p-tolyl)-2-propanon und 26,2 (0,11 mol) 4,4'-Dimethylbenzil wurden in 75 ml heißem Ethanol (abs.) gelöst. Es wurden unter Rühren 53 ml einer methanolischen Benzyltrimethylammoniumhydroxidlösung (0,11 mol Triton B, 35 % Fluka) langsam bei 80°C zugetropft (Vorsicht: der Reaktionsansatz schäumt stark) und noch 25 Minuten unter Rückfluss gekocht. Das Rohprodukt wurde nach drei Stunden abfiltriert, anschließend mit kaltem Ethanol gewaschen und aus Toluol umkristallisiert (violettrot, Ausbeute 46,2 g (95 %); Fp.: 244 - 245°C, Lit.: 250,4 - 251,4°C [15] Elementaranalyse für C₃₃H₃₉O: gef.: C 89,8 %, H 6,6 %, ber. : C 89,96 %, H 6,41 %, MS-E1 [m/z (rel. Intensität): M⁺ 440 (100), 412 (47), 206 (98), 191 (16), 189 (10)). Das IR-Spektrum von 1,2,3,4-Tetra(p-tolyl)cyclopenta-1,3-dien-5-on ist in Fig. 10 dargestellt.

### 1,2,3,4,-Tetra(p-tolyl)-5-p-vinylphenylcyclopenta-1,3-dien-5-ol

Das Grignardreagenz p-Vinylphenylmagnesiumbromid wurde aus 8,5 g (0,35 mol) Mg und 64,07 g (0,35 mol) p-Bromstyrol in 400 ml Ether bereitet. 26,5 g (0,06 mol) Tetra(p-tolyl)cyclopentadienon wurden portionsweise so zugegeben, dass die Lösung am Sieden gehalten wurde. Innerhalb von zwei Stunden färbte sich der Reaktionsansatz via dunkelorange nach hellgelb. Nach dem Abkühlen auf Raumtemperatur wurde langsam mit 200 ml 10 %-iger NH₄Cl-Lösung und dann mit verdünnter HCl hydrolisiert. Die etherische Phase wurde abgetrennt, und die wässrige Phase noch mehrmals mit Ether extrahiert. Die vereinigten organischen Phasen wurden mit NaHCO₃-Lösung gewaschen und über Na₂SO₄ getrocknet. Nach dem Abziehen des Ethers verblieb ein rotes Öl, das sich mit Hilfe einer Emulsion von Methanol und Heptan kristallisieren lässt. Das Rohprodukt wurde abgesaugt und mit Heptan gewaschen. Analysenreines Produkt wurde durch abermaliges Auskochen mit Heptan im Ultraschallbad erhalten (Ausbeute 26,11 g (80 %) ; Elementaranalyse für C₄₁H₃₆O: gef.: C 90,31 %, H 6,45 %, ber.: C 90,40 %, H 6,66 %

### 5,-Brom-1,2,3,4,-Tetra(p-tolyl)-5-p-vinylphenylcyclopenta-1,3-dien

34,32 g (0,063 mol) 1,2,3,4,-Tetra(p-tolyl)-5-p-vinylphenylcyclopenta-1,3-dien-5-ol wurden analog 1,2,3,4,-Tetraphenyl-5-p-vinylphenylcyclopenta-1,3-dien-5-ol mit 32 ml (52,8 g, 0,43 mol) Acetylbromid in Toluol bromiert (gelboranges Produkt, Ausbeute 31,73 g (83 %); Elementaranalyse für C₄₁H₃₅Br : gef.: C 80,51 %, H 5,86 %, ber.: C 81,04 %, H 5,81 %

### 1,2,3,4-Tetra-p-tolyl-5-p-vinylphenylcyclopenta-1,3-dien (M = 528,74 g/mol)

20,66 g (0,034 mol) 5-Brom-1,2,3,4,-Tetra(p-tolyl)-5-p-vinylphenylcyclopenta-1,3-dien wurden analog der Vorschrift zur Darstellung von 1,2,3,4,-Tetraphenyl-5-p-vinylphenyl-cyclopenta-1,3-dien mit 5,3 g Li[AlH₄] (0,14 mol) zu 1,2,3,4-Tetra-p-tolyl-5-p-vinylphenylcyclopenta-1,3-dien reduziert (leuchtend gelbes Produkt, Ausbeute 14,9 g (83 %); Elementaranalyse für C₄₁H₃₆: gef.: C 92,79 %, H 6,85 %, ber.: C 93,14 %, H 6,86 %

### Beispiel 4:

### Polymerisation

4,73 g (10 mmol) 1,2,3,4-Tetraphenyl-5-p-vinylphenylcyclopenta-1,3-dien werden in 150 ml warmem Xylol (Isomerengemisch, absolut) gelöst. Nach dem Abkühlen auf Raumtemperatur werden 10,42 g (100 mmol) über Schwefel frisch destilliertes Styrol zugegeben. Anschließend wird die Lösung mit 300 mg Benzoylperoxid in 20 ml Xylol versetzt. Nach Erhitzen auf 80°C für 6 Stunden wird die erkaltete Reaktionslösung langsam in Methanol getropft. Das ausgefallene gelbliche Polymer wird 8 Stunden im Vakuum getrocknet. Durch Aufnahme in Xylol und Ausfällen in Methanol werden 13,2 g (87 %) leicht fluoreszierendes gelbliches Polymer erhalten.

Anstelle von Benzoylperoxid wird 2,2'-Azobisisobutyronitril (AIBN) verwendet. Die Reaktion wird bei 70°C für 10 h geführt.

Anstelle eines Verhältnisses von 1 : 10 wird ein Polymer mit dem Verhältnis 1 : 15 hergestellt.

Anstelle eines Verhältnisses von 1 : 10 wird ein Polymer mit dem Verhältnis 1 : 7 hergestellt.

In obiges Polymer werden 0,92 g (5 mmol) Styrolsulfonsäure copolymerisiert.

In obiges Polymer werden 0,21 g (2 mmol) Vinylpyridin copolymerisiert.

Anstelle von 1,2,3,4-Tetraphenyl-5-p-vinylphenylcyclopenta-1,3-dien wird 1,2,3,4-Tetra(p-tolyl)-5-p-vinylphenylcyclopenta-1,3-dien polymerisiert.

### Beispiel 5:

### Schichtherstellung

2 g Polymer aus vorherigem Beispiel werden in 50 ml Xylol (Isomerengemisch) gelöst und durch einen 0,2 µm Teflonmembranfilter von Partikeln befreit. Die Lösung wird auf einen Siliziumwafer mit 100 nm thermischen Oxids für 20 s bei 2500 rpm aufgeschleudert. Der noch feuchte Wafer wird bei 100°C 2 min getrocknet. Restlösungsmittel wird in einem Ofen bei 100°C (nicht höher Tg Polymer) bei 100 mbar im N2 Strom (3 1/min) ausgetrieben. Die Endschichtdicke betrug 245 nm.

### Beispiel 6:

### Substratherstellung

Ein thermisch oxidierter Siliziumwafer (100 nm Oxid) wird mit 2 nm Titan und 50 nm Gold (Ar, 30 sscm, 4,5 µbar, 350 W) besputtert. Anschließend wird wie oben beschrieben, die Polymerschicht abgeschieden. Als Topelektroden werden durch eine Schattenmaske 1 mm große Dots aus Aluminium aufgedampft.

### Beispiel 7:

Der Hystereseeffekt wird mit einem Schaltkreis nach Fig. 3 gemessen. Der Spannungsabfall am Widerstand 6 (1 Mohm) dient als Sonde für den Zustand der Speicherzelle. Über den Schreibkreis 7 wird der Zustand der Speicherzelle 5 eingestellt. Wird die an die Speicherzelle 5 angelegte Spannung größer als die Schaltspannung Vₖᵣᵢₜ. der Speicherzelle 5, geht die Speicherzelle 5 in einen niederohmigen Zustand über. Dieser bleibt bestehen, solange die an der Speicherzelle 5 anliegende Spannung nicht unter einen Schwellenwert V_{hold} sinkt.

### Beispiel 8:

### 1,2,3,4-Tetraphenyl-5-p-hydroxyphenylcyclopenta-1,3-dien

### 1,2,3,4-Tetraphenyl-5-p-methoxyphenylcyclopenta-1,3-dien-5-ol

46,2 g (0,12 mol) Tetraphenylcyclopentadienon wurden mit 128,91 g (0,61 mol p-Methoxyphenyl-magnesiumbromid in 400 ml Ether und anschließender Hydrolyse zu 1,2,3,4-Tetraphenyl-5-p-methoxy-phenylcyclopenta-1,3-dien-5-ol umgesetzt. Elementaranalyse für C₃₆H₂₈O₂: gef.: C 87,72 %, H 5,73 %, ber.: C 87,78 %, H 5,73 %.

### 5-Brom-1,2,3,4-Tetralphenyl-5-p-methoxyphenylcyclolpenta-1,3-dien

54,19 g (0,11 mol) 1,2,3,4-Tetraphenyl-5-p-methoxyphenyl-cyclopenta-1,3-dien-5-ol wurden in 300 ml Toluol suspendiert. Innerhalb von 20 Minuten wurden bei Raumtemperatur 74 g (0,6 mol) Acetylbromid zugetropft und der Reaktionsansatz anschließend 2 Stunden unter Rückfluss gekocht. Gegen Ende der Reaktion wurden noch 2 ml Methanol tropfenweise zugegeben. Überschüssiges Acetylbromid und Toluol wurden im Vakuum abdestilliert. Das zurückbleibende Öl kristallisierte nach Zugabe von 100 ml Petrolether. Der orange Niederschlag wurde abgesaugt, mit Petrolether gewaschen und getrocknet. Das Produkt wurde für die weiteren Synthesen verwendet. Analysenreine orange Produkte wurden durch Rekristallisation aus Toluol erhalten. (Ausbeute: 54,32 g (89 %); Elementaranalyse für C₃₆H₂₇OBr: gef.: C 77,06 %, H 4,90 %, ber.: C 77,84 %, H 4,90 %).

### 5-Brom-1,2,3,4-Tetraphenyl-5-p-hydroxyphenylcyclopenta-1,3-dien

44,44 g (0,08 mol) 5-Brom-1,2,3,4-Tetraphenyl-5-p-methoxy-phenylcyclopenta-1,3-dien wurde in 400 ml konz. HBr 24 h im Rückfluss erhitzt. Das Produkt wurde abgesaugt und mit Wasser gewaschen. Es wurde in Toluol umkristallisiert. (Ausbeute: 35,05 g (81 %); Elementaranalyse für C₃₅H₂₅OBr: gef.: C 77,60 %, H 4,58 %, ber.: C 77,64 %, H 4,65 %).

### 1,2,3,4-Tetraphenyl-5-p-hydroxyphenylcyclopenta-1,3-dien

Zu einer Suspension von 15,18 g (0,4 mol) Li[AlH₄] in 200 ml Ether wurde portionsweise eine Suspension von 54,15 g (0,1 mol) 5-Brom-1,2,3,4-Tetraphenyl-5-p-hydroxyphenylcyclo-penta-1,3-dien in 300 ml Ether unter Rühren zugegeben. Die entstandene leicht gelbgraue Suspension wurde zur Vervollständigung der Reduktion noch 2 Stunden unter Rückfluss gekocht. Nach dem Abkühlen auf Raumtemperatur wurde überschüssiges Li[AlH₄] zunächst mit Eiswasser (Vorsicht: stürmische H₂-Entwicklung) und dann mit verdünnter Salzsäure hydrolysiert. Mit dem Rotationsverdampfer wurden anschließend alle flüchtigen organischen Bestandteile aus dem Reaktionsgemisch destilliert. Das leicht gelbe Rohprodukt wurde abgesaugt und mehrere Male mit Wasser gewaschen. Zur weiteren Reinigung wurde es mit Toluol azeotrop getrocknet, filtriert und umkristallisiert.
(Ausbeute 36,5 g (79 %); Elementaranalyse gef.: C 90,04 %, H 5,56 %, ber.: C 90,88 %, H 5,67 %)

### Beispiel 9:

### 1,2,3,4-Tetraphenyl-5-p-glycidyloxyphenylcyclopenta-1,3-dien

4,62 g (0,01 mol) 1,2,3,4-Tetraphenyl-5-p-hydroxyphenylcyclopenta-1,3-dien wurde in 150 ml Aceton gelöst. Unter Rühren wurde bei 10°C 1,85 g (0,02 mol) Epichlorhydrin zugegeben und anschließend bei 5°C 1,52 g (0,015 mol) Triethylamin gelöst in 20 ml Aceton langsam zugetropft. Es wurde 12 h bei Raumtemperatur gerührt. Der Reaktionsansatz wurde filtriert und das Aceton abrotiert. Der Rückstand wurde aus Chloroform-Methanol umgefällt.(Ausbeute: 3,83 g (74 %); Elementaranalyse: gef.: C 88,13 %, H 5,72 %, ber.: C 88,00 %, H 5,83 %)

### Beispiel 10:

### 1,2,3,4-Tetraphenyl-5-p-cyanuratophenylcyclopenta-1,3-dien

4,62 g (0,01 mol) 1,2,3,4-Tetraphenyl-5-p-hydroxyphenylcyclopenta-1,3-dien wurde in 300 ml Methylenchlorid gelöst und unter Rühren wurde bei 10°C 3,18 g (0,03 mol) Bromcyan zugegeben. Unter Eiskühlung wurden bei 0°C bis 5°C unter Rühren 3,04 g (0,03 mol) Triethylamin langsam zugetropft. Es wurde 5 h bei 20°C gerührt.

Die Reaktionsmischung wurde mit 100 ml Wasser versetzt und die organische Phase abgetrennt und über Natriumsulfat getrocknet. Das Methylenchlorid wurde abrotiert und der Rückstand aus Toluol/Ether bei max. 20°C umgefällt. (Ausbeute 3,8 g (78 %); Elementaranalyse: gef.: C 88,65 %, H 5,19 %, ber.: C 88,68 %, H 5,17 %, IR: OCN-Bande bei 2260 cm⁻¹) .

### Beispiel 11:

### 1,2,3,4-Tetraphenyl-5-p-methacryloxyphenylcyclopenta-1,3-dien

9,25 g (0,02 mol) 1,2,3,4-Tetraphenyl-5-p-hydroxyphenylcyclopenta-1,3-dien wurde in 200 ml trockenem Toluol gelöst und mit 4,62 g (0,03 mol) Methacrylsäureanhydrid versetzt und 12 h im Rückfluss erhitzt. Das Toluol wurde abrotiert und der Rückstand aus Aceton/Ether umgefällt. (Ausbeute 9,02 g (85 %); Elementaranalyse: gef.: C 88,35 %, H 5,61 %, ber.: C 88,27 %, H 5,70 %.)

### Beispiel 12:

### Polymer aus Methylmethacrylat und 1,2,3,4-Tetraphenyl-5-p-methacryloxyphenylcyclopenta-1,3-dien

5,3 g (0,01 mol) 1,2,3,4-Tetraphenyl-5-p-methacryloxyphenyl-cyclopenta-1,3-dien, 10 g (0,1 mol) frisch destillierter Methacrylsäuremethylester und 3,28 g (0,02 mol) 2,2'-Azobisisobutyronitril (AIBN) wurden 6 h bei 70°C unter Stickstoff in 200 ml trockenem Dioxan gerührt. Nach dem Abkühlen wurden das Polymer in 2 1 dest. Wasser gefällt und abgesaugt. Das Polymer wurde nach dem Trocknen aus Chloroform/Methanol umgefällt und getrocknet.

Anstelle von 2,2'-Azobisisobutyronitril (AIBN) wurde Benzoylperoxid verwendet. Die Reaktion wird bei 70°C für 10 h geführt.

Anstelle eines Verhältnisses von 1 : 10 wird ein Polymer mit dem Verhältnis 1 : 15 hergestellt.

Anstelle eines Verhältnisses von 1 : 10 wird ein Polymer mit dem Verhältnis 1 : 7 hergestellt.

## Patentansprüche

1. Organisches Polymer mit Halbleitereigenschaften, welches ein Polymerrückgrat und seitenständig an das Polymerrückgrat gebundene Pentaarylcyclopenta-1,3-dienylreste umfasst.

2. Polymer nach Anspruch 1, wobei der Pentaarylcyclopenta-1,3-dienylrest eine Struktur der Formel I 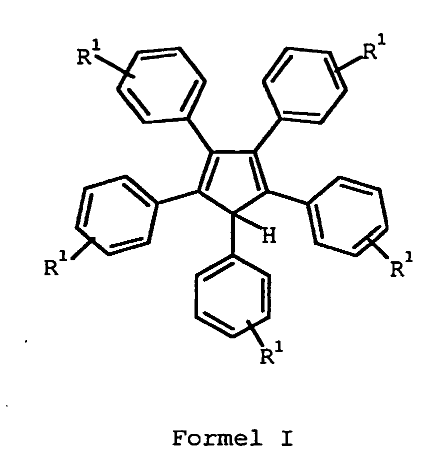 aufweist, wobei R¹ jeweils unabhängig für jede Position ein Wasserstoffatom, eine Alkylgruppe mit 1 bis 10 Kohlenstoffatomen, eine Arylgruppe mit 5 bis 20 Kohlenstoffatomen, wobei die Arylgruppe auch ein oder mehrfach substituiert sein kann, ein Halogenatom oder eine Alkoxygruppe mit 1 bis 10 Kohlenstoffatomen bedeutet, und einer der Phenylringe eine Gruppe A trägt, über welche der Pentaphenylcyclopenta-1,3-dienylrest seitenständig an das Polymerrückgrat gebundenen ist.

3. Polymer nach Anspruch 1 oder 2, wobei das Polymerrückgrat aus Kohlenstoffatomen aufgebaut ist.

4. Polymer nach einem der Ansprüche 1 bis 3, wobei an das Polymerrückgrat protische Gruppen gebunden sind.

5. Polymer nach einem der vorhergehenden Ansprüche, erhalten durch Copolymerisation eines ersten Comonomers, welches eine polymerisierbare Kohlenstoff-Kohlenstoff-Doppelbindung und einen Pentaarylcyclopenta-1,3-dienylrest aufweist, sowie zumindest eines zweiten Comonomers, das eine polymerisierbare Kohlenstoff-Kohlenstoff-Doppelbindung aufweist.

6. Polymer nach Anspruch 5, wobei das erste Comonomer eine Struktur der Formel I aufweist, und einer der Phenylringe eine Vinylgruppe oder eine (Meth)acryloxygruppe trägt.

7. Polymer nach einem der Ansprüche 5 oder 6, wobei das zweite Comonomer eine protische Gruppe aufweist.

8. Polymer nach einem der Ansprüche 5 bis 7, wobei das zweite Comonomer ausgewählt ist aus der Gruppe, die gebildet ist aus p-Styrolsulfonsäure, (Meth)acrylsäure, Vinylpyridin und Vinylpyrrolidinon.

9. Polymer nach einem der Ansprüche 5 bis 8, wobei erstes und zweites Comonomer in einem molaren Verhältnis von 1 : 1 bis 100 : 1 im Polymer enthalten sind.

10. Resistives Speicherelement mit einer Speicherzelle, welche zumindest einen ansteuerbaren ersten Kontakt, einen zweiten Kontakt und ein zwischen erstem und zweitem Kontakt angeordnetes Speichermedium umfasst, wobei das Speichermedium aus einem Polymer nach einem der Ansprüche 1 bis 9 gebildet ist.

11. Resistives Speicherelement nach Anspruch 10, wobei erster und zweiter Kontakt aus einem unterschiedlichen Material aufgebaut sind.

12. Resistives Speicherelement nach Anspruch 10 oder 11, wobei erster und zweiter Kontakt aus einem Metall aufgebaut sind.

13. Resistives Speicherelement nach einem der Ansprüche 10 bis 12, wobei ein konstanter Widerstand vorgesehen ist, welcher in Serie zur Speicherzelle geschaltet ist.

14. Speicherfeld, umfassend zumindest zwei zwischen zwei Informationszuständen schaltbare Speicherelementen nach einem der Ansprüche 10 bis 13, wobei eine Steuereinrichtung vorgesehen ist, mit welcher der Informationszustand jedes Speicherelements gesteuert werden kann.

## Claims

1. Organic polymer having semiconductor properties, which comprises a polymer backbone and pentaarylcyclopenta-1,3-dienyl radicals bonded as side groups to the polymer backbone.

2. Polymer according to Claim 1, the pentaaryl-cyclopenta-1,3-dienyl radical having a structure of the formula I 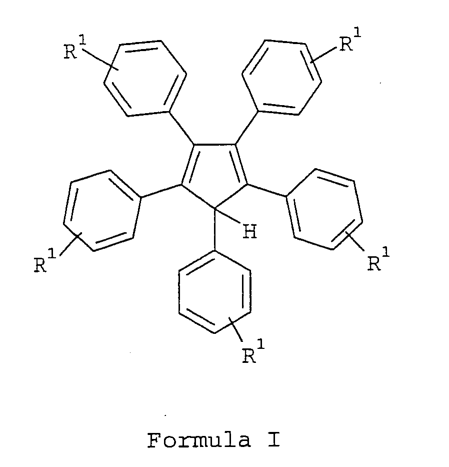 in which R¹, in each case independently for each position, is a hydrogen atom, an alkyl group having 1 to 10 carbon atoms, an aryl group having 5 to 20 carbon atoms, it also being possible for the aryl group to be mono- or polysubstituted, a halogen atom or an alkoxy group having 1 to 10 carbon atoms, and one of the phenyl rings carries a group A via which the pentaphenylcyclopenta-1,3-dienyl radical is bonded as a side group to the polymer backbone.

3. Polymer according to Claim 1 or 2, the polymer backbone being composed of carbon atoms.

4. Polymer according to any of Claims 1 to 3, protic groups being bonded to the polymer backbone.

5. Polymer according to any of the preceding claims, obtained by copolymerization of a first comonomer which has a polymerizable carbon-carbon double bond and a pentaarylcyclopenta-1,3-dienyl radical and at least one second comonomer which has a polymerizable carbon-carbon double bond.

6. Polymer according to Claim 5, the first comonomer having a structure of the formula I, and one of the phenyl rings carrying a vinyl group or a (meth)acryloyloxy group.

7. Polymer according to either of Claims 5 and 6, the second comonomer having a protic group.

8. Polymer according to any of Claims 5 to 7, the second comonomer being selected from the group consisting of p-styrenesulfonic acid, (meth)acrylic acid, vinylpyridine and vinylpyrrolidone.

9. Polymer according to any of Claims 5 to 8, first and second comonomer being contained in the polymer in a molar ratio of from 1 : 1 to 100 : 1.

10. Resistive memory element having a memory cell which comprises at least one actuatable first contact, one second contact and one storage medium arranged between first and second contacts, the storage medium being formed from a polymer according to any of Claims 1 to 9.

11. Resistive memory element according to Claim 10, first and second contacts being composed of different materials.

12. Resistive memory element according to Claim 10 or 11, first and second contacts being composed of a metal.

13. Resistive memory element according to any of Claims 10 to 12, a constant resistance which is connected in series with the memory cell being provided.

14. Memory field comprising at least two memory elements according to any of Claims 10 to 13, which can be switched between two information states, a control device by means of which the information state of each memory element can be controlled being provided.

## Revendications

1. Polymère organique présentant des propriétés semi-conductrices, qui comprend un squelette polymère et des radicaux de pentaarylcyclopenta-1,3-diényle liés latéralement au squelette polymère.

2. Polymère selon la revendication 1, dans lequel le radical pentaarylcyclopenta-1,3-diényle a une structure de Formule I 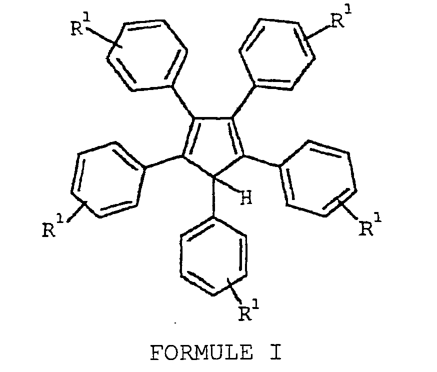 dans laquelle chaque R¹, pour chaque position, représente d'une manière indépendante un atome d'hydrogène, un groupe alkyle ayant 1 à 10 atomes de carbone, un groupe aryle ayant 5 à 20 atomes de carbone, le groupe aryle pouvant aussi être une ou plusieurs fois substitué, un atome d'halogène ou un groupe aryle ayant 1 à 10 atomes de carbone, et l'un des noyaux phényle porte un groupe A, par l'intermédiaire duquel le radical pentaphénylcyclopenta-1,3-diényle est lié latéralement au squelette polymère.

3. Polymère selon la revendication 1 ou 2, dans lequel le squelette polymère est constitué d'atomes de carbone.

4. Polymère selon l'une des revendications 1 à 3, dans lequel des groupes protiques sont liés au squelette polymère.

5. Polymère selon l'une des revendications précédentes, obtenu par copolymérisation d'un premier comonomère qui présente une double liaison carbone-carbone polymérisable et un radical pentaphénylcyclopenta-1,3-diényle, ainsi que d'au moins un deuxième comonomère, qui comprend une double liaison carbone-carbone polymérisable.

6. Polymère selon la revendication 5, dans lequel le premier comonomère a une structure de Formule I, et l'un des noyaux phényle porte un groupe vinyle ou un groupe (méth)acryloxy.

7. Polymère selon l'une des revendications 5 ou 6, où le deuxième comonomère comprend un groupe protique.

8. Polymère selon l'une des revendications 5 à 7, dans lequel le deuxième comonomère est choisi dans le groupe formé de l'acide p-styrènesulfonique, de l'acide (méth)acrylique, de la vinylpyridine et de la vinyl-pyrrolidinone.

9. Polymère selon l'une des revendications 5 à 8, dans lequel le premier et le deuxième comonomères sont présents dans le copolymère selon un rapport en moles de 1:1 à 100:1.

10. Elément de mémoire résistif comportant une cellule de mémoire, qui comprend au moins un premier contact pouvant être commandé, un deuxième contact, et un support de mémoire disposé entre le premier et le deuxième contact, le support de mémoire étant formé d'un polymère selon l'une des revendications 1 à 9.

11. Elément de mémoire résistif selon la revendication 10, dans lequel le premier et le deuxième contacts sont constitués de matériaux différents.

12. Elément de mémoire résistif selon la revendication 10 ou 11, dans lequel le premier et le deuxième contacts sont constitués de métaux.

13. Elément de mémoire résistif selon l'une des revendications 10 à 12, dans lequel il est prévu une résistance constante, montée en série avec la cellule de mémoire.

14. Champ de mémoire comprenant au moins deux éléments de mémoire commutables entre deux états d'information selon l'une des revendications 10 à 13, dans lequel il est prévu un dispositif de commande à l'aide duquel il est possible de piloter l'état d'information de chaque élément de mémoire.
